# EUROPÄISCHE PATENTANMELDUNG

(11) **EP 0 763 746 A2**
(43) Veröffentlichungstag der Anmeldung: **19.03.1997**
(21) Anmeldenummer: 96114647.9
(22) Anmeldetag: 12.09.1996
(51) Int. Cl.: G01R 31/02

(54) **Schaltungsanordnung zum Erkennen des Leerlaufs einer Last**

(30) Priorität: 18.09.1995 DE 19534603
(71) Anmelder: SIEMENS AKTIENGESELLSCHAFT, 80333 München (DE)
(72) Erfinder: Tihanyi, Jenö, Dr.-Ing., 85551 Kirchheim (DE)

(57) **Zusammenfassung**

Bei Leistungsschaltern soll häufig gemeldet werden, wenn die Last hochohmig wird und der Laststrom unter einen vorgegebenen Wert sinkt. Der Spannungsabfall am Leistungsschalter (1) ist im Leerlauffall jedoch sehr niedrig und daher nur mit Ungenauigkeiten meßbar. Eine genaue Erfassung der Reduktion des Laststromes ist möglich, wenn der Laststrecke des Leistungsschalters (1) im eingeschalteten Zustand ein Widerstand (7) parallel geschaltet wird. Der Widerstandswert RM dieses Widerstandes (7) ist um ein Vielfaches größer als der Widerstandswert des Innenwiderstandes der Laststrecke des Leistungsschalters (1). Ein Komparator (11) vergleicht die an der Laststrecke des Leistungsschalters (1) und damit am Widerstand (7) abfallende Spannung (U2) mit einer vorgegebenen Referenzspannung (U1) und signalisiert das Absinken des Laststromes unter einen durch das Verhältnis aus Referenzspannung und Widerstandswert RM gegebenen Wert.

## Beschreibung

Die Erfindung betrifft eine Schaltungsanordnung zum Erkennen des Leerlaufs einer Last nach den Merkmalen des Oberbegriffs des Anspruchs 1.

Für viele Anwendungszwecke ist es erwünscht, den Ausfall einer Last zu erkennen und zu melden, sobald der Laststrom unter einen vorgegebenen Wert sinkt. Da die Last selbst häufig vom Leistungsschalter räumlich entfernt angeordnet ist, scheidet die Überwachung der an der Last abfallenden Spannung zur Erkennung des Leerlauffalles aufgrund der in diesem Fall zusätzlich notwendigen Leitungen aus.

Um zu vermeiden, den Spannungsabfalls an der Last messen zu müssen, ist es bereits bekannt, den Spannungsabfall an der Laststrecke des Leistungsschalters zu messen. Dieser Wert ist jedoch insbesondere bei der Verwendung von Leistungs-MOS-FET äußerst niedrig. Im Leerlauffall, also bei hochohmiger Last, wie z. B. bei einer defekten Glühlampe; und eingeschalteten Leistungs-MOS-FET, liegt der Spannungsabfall in der Praxis bei etwa 1 bis 10 m Volt und ist daher nur mit Ungenauigkeiten meßbar. Des weiteren variiert dieser niedrige Spannungsabfall aufgrund von Herstellungstoleranzen.

In der EP 0 365 697 B1 ist bereits eine Schaltungsanordnung zum Erkennen des Leerlaufs einer Last beschrieben. Die Schaltungsanordnung weist einen Leistungs-MOS-FET mit sourceseitiger Last auf und verfügt über einen ausgangsseitig den Leerlauf signalisierenden Komparator. Dieser Komparator vergleicht die an der Laststrecke des Leistungs-MOS-FET abfallende Spannung mit einer Referenzspannung, die derart bemessen ist, daß sie absolut kleiner ist als diejenige Spannung ist, die dann am Leistungs-MOS-FET abfällt, wenn die Last nicht unterbrochen ist, also bei durch die Last fließenden Nennstrom, und andererseits absolut größer ist, als diejenige Spannung, die am Leistungs-MOS-FET dann abfällt, wenn die Last unterbrochen ist. Ein Lastausfall erzeugt am Ausgang des Komparators einen Spannungssprung, der als Anzeige für den Leerlauf der Last ausgewertet wird. Für eine eindeutige Festlegung der im Leerlauffall am Leistungs-MOS-FET abfallenden Spannung muß eine Stromquelle parallel zur Last geschaltet werden. Der Strom der Stromquelle ist um ein vielfaches kleiner als der Laststrom im Nennbetrieb, also bei intakter Last, zu wählen.

Problematisch bei dieser Lösung ist die zwingende Verwendung einer parallel zur Last geschalteten Stromquelle, die den Stromverbrauch der Schaltungsanordnung erhöht und selbst im Leerlauffall für einen Stromfluß durch den Leistungs-MOS-FET sorgt und damit Verlustleistung verursacht.

Zweck der vorliegenden Erfindung ist es, eine Schaltungsanordnung der eingangs erwähnten Gattung anzugeben, mit der der Leerlauf, d.h. die Unterbrechung einer Last, an einen von diesem entfernten Ort ohne zusätzliche Leitungen in einfacher Weise noch genauer detektiert werden kann und deren Stromverbrauch deutlich reduziert ist.

Dieses Ziel wird erreicht durch einen ausschließlich im eingeschalteten Zustand des Leistungsschalters zur Laststrecke des Leistungsschalters parallel geschalteten Widerstand mit einem größeren Widerstandswert als der Innenwiderstand der Laststrecke des Leistungsschalters bei dessen eingeschaltetem Zustand.

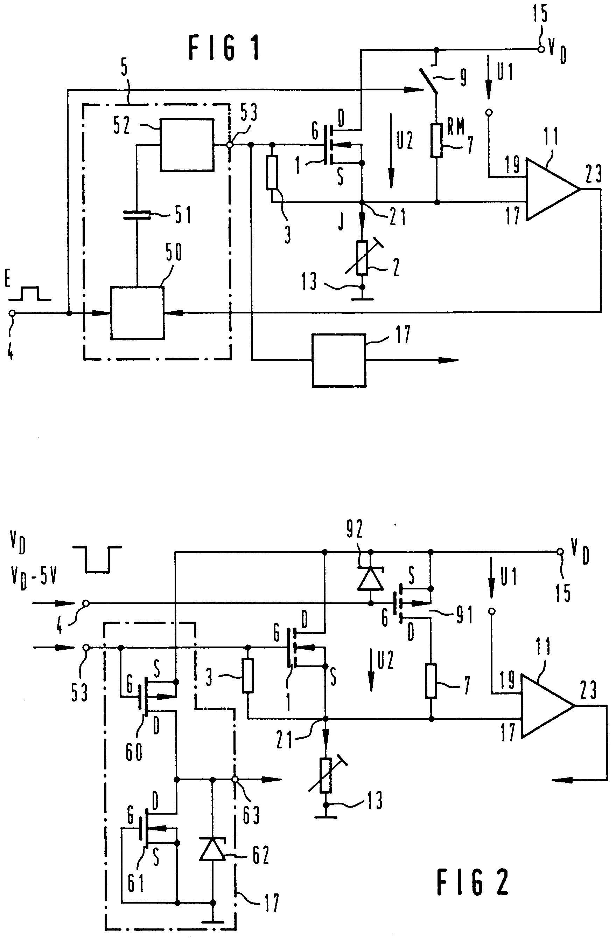

Weiterbildungen der Erfindung sind Gegenstand der Unteransprüche. Die Erfindung wird anhand eines Ausführungsbeispieles in Verbindung mit Figur 1 näher erläutert. In Figur 2 ist die in Figur 1 dargestellte Schaltungsanordnung mit Ausgestaltungen einzelner Schaltungskomponenten gezeigt.

Die Schaltungsanordnung nach Figur 1 enthält einen LeistungsMOS-FET 1, dem sourceseitig eine Last 2 in Reihe geschaltet ist. Die Reihenschaltung von Leistungs-MOS-FET 1 und Last 2 liegt zwischen den Klemmen 13 und 15, an denen eine Versorgungsspannung V_{D} anliegt. Das Versorgungspotential V_{D} ist an die Klemme 15 und das Bezugspotential an die Klemme 13 gelegt. Der Drainanschluß D des Leistungs-MOS-FET 1 ist mit der Klemme 15 in Verbindung, während der Sourceanschluß S und ein Anschluß der Last 2 an den gemeinsamen Verbindungspunkt 21 der Reihenschaltung geschaltet sind. Der andere Anschluß der Last 2 ist an die Klemme 13 geschaltet. Der Gateanschluß G des Leitungs-MOS-FET 1 wird von einer an sich bekannten Ladungspumpe 5 angesteuert.

Die Ladungspumpe 5 besteht im wesentlichen aus der Reihenschaltung eines Oszillators 50, einer kapazitiven Einrichtung 51 mit einem oder mehreren Kondensatoren, welche in Reihe zwischen den Ausgang des Oszillators 50 und den Eingang eines Ladegleichrichters 52 geschaltet ist, bzw. sind. Der Oszillator 50, der Ladungspumpe 5 ist von einem Eingangssignal E aktivierbar. Dieses Eingangssignal E, das in Figur 1 an die Klemme 4 anlegbar ist, dient zum Einschalten des Leistungs-MOS-FET 1. Das Eingangssignal E bewirkt das Einschalten des Oszillators 50 der Ladungspumpe 5, wodurch an der Ausgangsklemme 53 der Ladungspumpe 5 ein im Vergleich zum Versorgungspotential V_{D} erhöhtes Potential ansteht. Beträgt beispielsweise das Versorgungspotential + 15 Volt, so stehen bei aktivierter Ladungspumpe an der Klemme 53 beispielsweise 25 Volt an, so daß der Leistungs-MOS-FET 1 sicher einschaltet. Das Gatepotential am Gateanschluß G des Leistungs-MOS-FET 1 wird somit im eingeschalteten Zustand mit ausreichend positiver Spannung aus der Ladungspumpe 5 versorgt. Ein zwischen den Gateanschluß G und des Sourceanschluß S des Leistungs-MOS-FET 1 geschalteter Entladewiderstand 3 entlädt die Gate-Source-Kapazität des Leistungs-MOS-FET 1, sobald der Pumpvorgang der Ladungspumpe 5, beispielsweise durch Abschalten des Oszillators 50, weil das Eingangssignal E auf niedrigen Pegel fällt, aufhört.

Die bisher beschriebene Schaltungsanordnung ist als solche zur Ansteuerung von Leistungs-MOS-FET mit sourceseitiger Last bekannt.

Zum Erkennen des Leerlaufs der Last 2 ist die Schaltungsanordnung folgendermaßen erweitert. Parallel zur Laststrecke des Leistungs-MOS-FET 1 ist die Reihenschaltung einer Schalteinrichtung 9 und eines vorzugsweise temperaturunabhängigen Widerstandes 7 geschaltet. Der Widerstand 7 dient als Meßwiderstand und weist einen größeren Widerstandswert RM als der Innenwiderstand der Laststrecke des Leistungs-MOS-FET 1 bei dessen eingeschaltetem Zustand auf. Der Widerstandswert RM des Widerstandes 7 ist vorzugsweise vielfach, z. B. etwa 100 bis 1000 mal größer als der Widerstandswert der Laststrecke des Leistungs-MOS-FET 1. Die Schalteinrichtung 9 wird so angesteuert, daß der Widerstand 7 genau immer dann der Laststrecke des Leistungs-MOS-FET 1 parallel geschaltet ist, wenn sich der Leistungs-MOS-FET 1 aufgrund des Eingangssignales E an der Klemme 4 im eingeschalteten Zustand befinden soll.

Des weiteren verfügt die Schaltungsanordnung in Figur 1 über einen Komparator 11 mit einem ersten Eingang 17 und einem zweiten Eingang 19. Der erste Eingang 17 des Komparators 11 ist an dem Verbindungspunkt 21 der Reihenschaltung aus Leistungs-MOS-FET 1 und Last 2 geschaltet. Der zweite Eingang 19 ist an eine Referenzspannung U1 gelegt. Wie anhand der Spannungspfeile in Figur 1 ersichtlich, liegt somit am ersten Eingang 17 des Komparators 11 die an der Laststrecke des Leistungs-MOS-FET 1 und damit auch am Widerstand 7 abfallende Spannung U2 an, während der zweite Eingang 19 des Komparators 11, bezogen auf das Versorgungspotential V_{D} von der Referenzspannung U1 beaufschlagt wird. Der Ausgang 23 des Komparators 11 ist zur Steuerung der Ladungspumpe 5 vorgesehen, so daß das Potential an der Klemme 53 veränderbar ist. Die Potentialänderung an der Klemme 53 der Ladungspumpe 5 dient, sofern die Einsatzspannung des Leistungs-MOS-FET 1 überschritten bleibt, zur Änderung des Widerstandes der Laststrecke des Leistungs-MOS-FET 1. Das Potential an der Klemme 53 der Ladungspumpe ist über eine noch zu erläuternde Detektionseinrichtung auswertbar.

Für eine sichere Erkennung des Leerlaufes der Last 2 ist es notwendig, daß die Referenzspannung U1 so gewählt ist, daß im normalen Betrieb der Pumpvorgang der Ladungspumpe 5 voll in Betrieb ist. Dies bedeutet, daß der Oszillator 50 der Ladungspumpe 5 schwingen muß. Hierfür ist die Referenzspannung U1 so gewählt, daß diese kleiner als das bei Normalbetrieb am Verbindungspunkt 21 abgreifbare Potential und andererseits größer als das bei Leerlauf am Verbindungspunkt 21 abgreifbare Potential, jeweils bezogen auf das Versorgungspotential V_{D}, ist. Die Referenzspannung U1 kann beispielsweise 0,2 Volt betragen. Zwischen der Klemme 15 und dem zweiten Eingang 19 des Komparators 11 liegt somit die Referenzspannung U1 von 0,2 Volt an. Die Klemme 19 liegt damit bei einer angenommenen Versorgungsspannung V_{D} von + 15 Volt bezogen auf die Klemme 13 und damit Bezugspotential auf 14,8 Volt. Solange die Spannung U2 größer als die Referenzspannung U1 ist, läuft voraussetzungsgemäß der Oszillator 50. Ist dagegen die Spannung U2 kleiner als die Referenzspannung U1, wie es im Leerlauffall eintritt, läuft dagegen der Oszillator 50 der Ladungspumpe 5 nicht. Im Nennbetrieb ist jedoch der Laststrom I durch die Last 2 so hoch, daß die Spannung U2 voraussetzungsgemäß größer als die Referenzspannung U1 ist, wodurch der Ladungspumpvorgang voll im Betrieb bleibt.

Wird der Widerstand der Last 2 hochohmig, zum Beispiel infolge eines Defekts, beginnt der Laststrom I augenblicklich auf Null oder nahezu auf Null zu sinken. Die Spannung U2 beginnt ebenfalls zu sinken und nähert sich zunächst dem Wert der Referenzspannung U1, so daß das Potential am Ausgang 23 des Komparators 11 reduziert wird. Hierdurch wird ebenfalls das Gatepotential des Leistungs-MOS-FET 1 abgesenkt. Das Gatepotential des Leistungs-Mos-FET 1 wird sich anschließend so einpendeln, daß sich am Verbindungspunkt 21 gerade die Referenzspannung U1 einstellt. Sinkt der Laststrom I weiter, wird das Gatepotential des Leistungs-MOS-FET 1 weiter reduziert, und zwar solange, daß am Ende der Pumpvorgang völlig eingestellt wird. Der Laststrom I reicht dann nicht mehr aus, um am Widerstand 7 die Referenzspannung U1 zu erreichen. Als Folge hiervon erreicht der Ausgang 23 des Komparators 11 seinen "0"-Pegel wodurch der Oszillator 50 der Ladungspumpe 5 trotz Anliegen des Einschaltsignales E an der Klemme 4 abgeschaltet wird. Hierbei sinkt das Gatepotential an der Klemme 53 unter die Einsatzspannung, so daß der Leistungs-MOS-FET abschaltet.

Die Detektionseinrichtung 17 detektiert den Zustand, daß das Gatepotential des Leistungs-MOS-FET 1 unter die Einsatzspannung abgesunken ist. Die Detektionseinrichtung 17 erfaßt und zeigt an, daß der Laststrom I kleiner als sein Schwellenwert U1/RM ist. Durch die Dimensionierung von U1 und RM kann somit exakt die auszuwertende Stromschwelle für die Leerlaufdetektion eingestellt werden.

In Figur 2 sind Ausgestaltungen einzelner Komponenten, der in Figur 1 dargestellten Schaltungsanordnung gezeigt. Die Detektionseinrichtung 17 weist zwei zueinander komplementäre und in Reihe geschaltete Depletion-MOS-FET 60, 61 auf. Der MOS-FET 60 ist ein p-Kanal MOS-FET und liegt mit seinem Drainanschluß D an der Klemme 15 und damit am Versorgungspotential V_{D}. Der Gateanschluß G dieses MOS-FET 60 ist mit dem Gateanschluß G des Leistungs-MOS-FET 1 in Verbindung. Der Sourceanschluß S des MOS-FET 60 ist mit dem Drainanschluß D des n-Kanal MOS-FET 61 in Verbindung, dessen Gateanschluß G und Sourceanschluß S sind an Bezugspotential geschaltet. Parallel zur Laststrecke des MOS-FET 61 ist eine Zenerdiode 62 zur Spannungsbegrenzung geschaltet. Der Kathodenanschluß der Zenerdiode 62 ist mit dem Verbindungspunkt der beiden MOS-FET 60, 61 in Verbindung. Dieser Verbindungspunkt bildet zugleich die Ausgangsklemme 63 der Detektionseinrichtung 17.

Die Erfassung des Gatepotentiales bei vorliegender Schaltungsanordnung zur Leerlauferkennung bietet den entscheidenen Vorteil, daß ein verhältnismäßig hoher Spannungshub, der leichter auszuwerten ist, als Kriterium für die Leerlauferkennung ausgenutzt werden kann.

Die im Zusammenhang mit Figur 1 erläuterte Schalteinrichtung 9 zum Parallelschalten des Widerstandes 7 an die Laststrecke des Leistungs-MOS-FET 1 kann ebenfalls als MOS-FET realisiert sein. Wie in Figur 2 dargestellt, bietet sich hierfür ein p-Kanal-Enhancement- MOS-FET 91 an, der mit seinem Drainanschluß D an die Klemme 15 und mit seinem Sourceanschluß S an den Widerstand 7 geschaltet ist. Der Gateanschluß G dieses MOS-FET 91 wird von einem Signal beaufschlagt, der den MOS-FET 91 dann einschaltet, wenn auch der Leistungs-MOS-FET 1 eingeschaltet sein soll. Hierfür kann der Gateanschluß G des MOS-FET 91 beispielsweise gemäß der Darstellung in Figur 2 mit einem im Einschaltfall vom Potential V_{D} auf Low-Pegel, (z.B. auf V_{D} minus 5 Volt), fallenden Signal an der Klemme 4 angesteuert werden . Zusätzlich ist zwischen den Gateanschluß G und den Drainanschluß D des MOS-FET 91 eine weitere Zenerdiode 92 zur Spannungsbegrenzung geschaltet. Der Kathodenanschluß dieser Zenerdiode 92 ist hierbei an die Klemme 15 geschaltet.

In einer bevorzugten Weiterbildung der Erfindung kann der Widerstand 7 und der MOS-FET 91, gegebenenfalls mit der Zenerdiode 92 zusammen mit dem Leistungs-MOS-FET 1 auf einem gemeinsamen Halbleitersubstrat integriert sein. Auch die übrigen Komponenten der erfindungsgemäßen Schaltungsanordnung können auf einem solchen Halbleitersubstrat ausgebildet werden. Es bietet sich an, den Entladewiderstand 3 ebenfalls als MOS-FET auszuführen, beispielsweise als Depletion-MOS-FET. Der Entladewiderstand 3 hat zweckmäßigerweise einen sehr hochohmigen Innenwiderstand, beispielsweise 100 kOhm bis 10 MOhm, um so lange Zeitkonstanten beim Entladevorgang der Gate-Source-Kapazität des Leistungs-MOS-FET 1 zu erreichen.

## Patentansprüche

1. Schaltungsanordnung zum Erkennen des Leerlaufes einer Last (2), die mit einem elektronischen Leistungsschalter (1) in Reihe geschaltet ist, mit einem ausgangsseitig den Leerlauf signalisierenden Komparator (11), dessen erster Eingang (17) an den Verbindungspunkt (21) des Leistungsschalters (1) und der Last (2) geschaltet und dessen anderer Eingang (19) an eine Referenzspannung (U1) geschaltet ist, welche kleiner als die bei Nennstrom am Leistungsschalter (1) abfallende Spannung (U2) und größer als die bei Leerlauf am Leistungsschalter (1) abfallende Spannung (U2) ist, **gekennzeichnet** durch einen ausschließlich im eingeschalteten Zustand des Leistungsschalters (1) zur Laststrecke des Leistungsschalters (1) parallel geschalteten Widerstand (7) mit einem größeren Widerstandswert (RM) als der Innenwiderstand der Laststrecke des Leistungsschalters (1) bei dessen eingeschalteten Zustand.

2. Schaltungsanordnung nach Anspruch 1,
**dadurch gekennzeichnet**, daß der parallel zur Laststrecke des Leistungsschalters (1) zuschaltbare Widerstand (7) temperaturunabhängig ist.

3. Schaltungsanordnung nach Anspruch 1 oder 2,
**dadurch gekennzeichnet,** daß der parallel zur Laststrecke des Leistungsschalters (1) schaltbare Widerstand (7) einen etwa 100 - 1000 mal größeren Widerstandswert (RM) als der Widerstand der Laststrecke des Leistungsschalters (1) bei dessen eingeschaltetem Zustand aufweist.

4. Schaltungsanordnung nach einem der Ansprüche 1 bis 3,
**dadurch gekennzeichnet,** daß der Leistungsschalter (1) ein von einer Ladungspumpe (5) ansteuerbarer MOS-FET ist, mit zwischen Gateanschluß (G) und Sourceanschluß (S) geschalteten Entladewiderstand (3), und daß das Ausgangssignal des Komparators (11) zur Steuerung der Ladungspumpe (5) vorgesehen ist.

5. Schaltungsanordnung nach Anspruch 4,
**dadurch gekennzeichnet,** daß die Ladungspumpe (5) die Reihenschaltung eines Oszillators (50), einer Kapazitätseinrichtung (51) und eines Ladegleichrichters (52) aufweist, und daß das Ausgangssignal des Komparators (11) zum Ein- bzw. Ausschalten des Oszillators (50) vorgesehen ist, sofern am ersten Eingang (17) des Komparators (11) eine größere bzw. kleinere Spannung (U2) als die Referenzspannung (U1) anliegt.

6. Schaltungsanordnung nach Anspruch 4 oder 5,
**dadurch gekennzeichnet,** daß der Entladewiderstand (3) als MOS-FET mit einem Widerstandswert von etwa 100 kOhm bis 10 mOhm ausgebildet ist.

7. Schaltungsanordnung nach einem der Ansprüche 4 bis 6,
**dadurch gekennzeichnet,** daß eine Detektionseinrichtung (6) vorgesehen ist zur Erfassung des am Gateanschlusses (G) des MOS-FET anliegenden Gatepotentials und zum Signalisieren des Leerlaufes der Last (2), sobald das Gatepotential unter die Einsatzspannung des MOS-FET (1) gesunken ist.

8. Schaltungsanordnung nach Anspruch 7,
**dadurch gekennzeichnet,** daß die Detektionseinrichtung (6) eine zwischen zwei Klemmen (13, 15) einer Versorgungsspannung geschaltete Reihenschaltung zweier komplementärer MOS-FET (60, 61) aufweist, daß der Gateanschluß (G) des einen MOS-FET (60) mit dem Gateanschluß (G) des als Leistungsschalter (1) dienenden MOS-FET verbunden ist, und daß der Gateanschluß (G) des anderen MOS-FET (61) an die Klemme (13) für Bezugspotential geschaltet ist, und daß parallel zu der Laststrecke des anderen MOS-FET (61) eine Zenerdiode (62) geschaltet ist.

9. Schaltungsanordnung nach einem der Ansprüche 1 bis 8,
**dadurch gekennzeichnet**, daß der zur Laststrecke des Leistungsschalters (1) parallel schaltbare Widerstand (7) in Reihe zu einer Schalteinrichtung (9) liegt, und daß die Schalteinrichtung (9) gleichzeitig mit dem Leistungsschalter (1) ein- und ausschaltbar ist.

10. Schaltungsanordnung nach Anspruch 9,
**dadurch gekennzeichnet,** daß die Schalteinrichtung (9) und der Widerstand (7) in den Leistungsschalter (1) integriert sind.

11. Schaltungsanordnung nach Anspruch 9 oder 10,
**dadurch gekennzeichnet,** daß die Schalteinrichtung (9) ein MOS-FET (91) ist.
